(19) **Europäisches Patentamt**

**European Patent Office**

**Office européen des brevets**

(11) **EP 0 778 669 B1**

(12) **FASCICULE DE BREVET EUROPEEN**

(45) Date de publication et mention
de la délivrance du brevet:
**16.03.2005 Bulletin 2005/11**

(51) Int Cl.⁷: **H03K 9/06**

(21) Numéro de dépôt: **96402899.7**

(22) Date de dépôt: **26.12.1996**

(54) **Démodulateur de fréquence**

Frequenzdemodulator

Frequency demodulator

(84) Etats contractants désignés:
**DE FR GB**

(30) Priorité: **29.12.1995 FR 9515746**

(43) Date de publication de la demande:
**11.06.1997 Bulletin 1997/24**

(73) Titulaire: **THOMSON BROADCAST SYSTEMS
95801 Cergy-Pontoise Cedex (FR)**

(72) Inventeurs:
• **Claverie, Claude
92050 Paris la Défense 5 (FR)**
• **Guitton, Xavier
92050 Paris la Défense 5 (FR)**

(74) Mandataire: **Brykman, Georges
THOMSON multimedia,
46 quai A. Le Gallo
92648 Boulogne Cédex (FR)**

(56) Documents cités:
**US-A- 3 594 588 US-A- 3 824 410
US-A- 4 280 100 US-A- 4 350 957**

## Description

L'invention définie dans les revendications se situe dans le domaine des démodulateurs de fréquence.

Il est connu que pour démoduler une onde modulée en fréquence, il suffit de générer à partir de cette onde des impulsions ayant une même durée déterminée, indépendante de la fréquence des ondes et une fréquence d'occurrence proportionnelle à cette fréquence, puis d'intégrer ces impulsions, pour obtenir un niveau proportionnel à la fréquence à démoduler. Le document US-A-4 350 957 divulgue un dispositif qui met en oeuvre cette méthode.

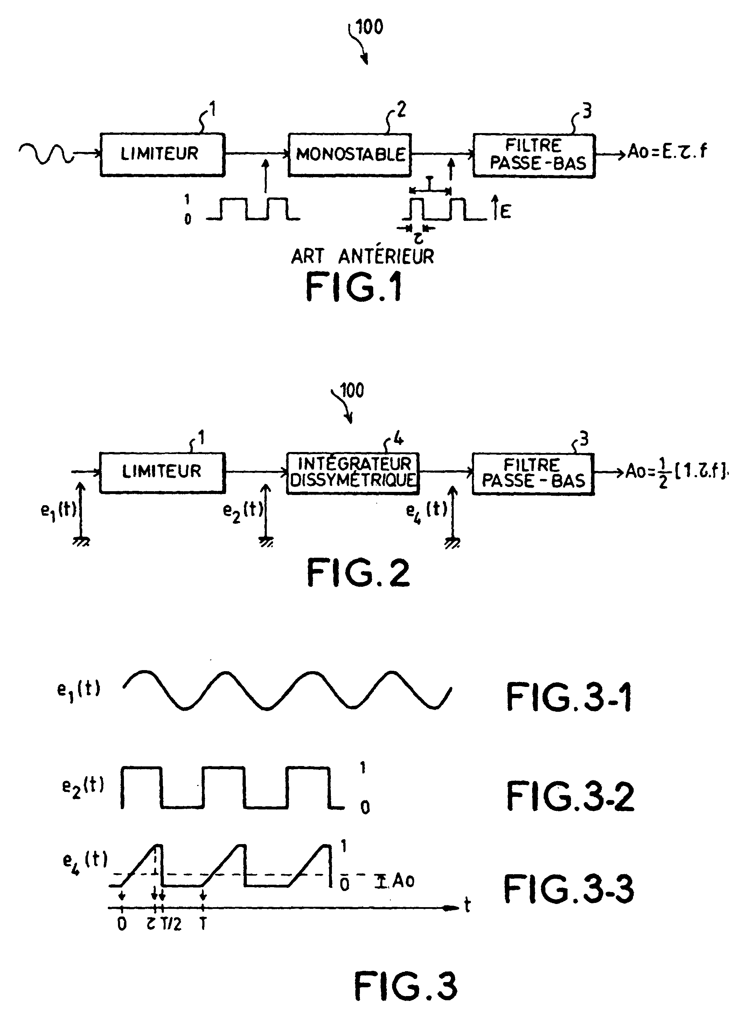

Plusieurs dispositifs permettent de réaliser cette fonction : l'un d'eux représenté figure 1 utilise un circuit limiteur 1 disposé en série avec une bascule monostable 2 et un filtre passe bas 3. Le circuit limiteur 1 écrête le signal modulé en fréquence ; il délivre ainsi des signaux caractérisés par deux niveaux d'amplitude O-E modulés en fréquence à partir desquels la bascule monostable 2 délivre des impulsions de durée $\tau = C^{te}$ de fréquence de récurrence variable, dont le filtre passe bas 3 extrait la valeur moyenne. En raison des performances des monostables disponibles, cette solution est limitée à une fréquence maximale de fonctionnement correcte $\leq$ 10 MHz, ce qui est notoirement insuffisant pour acheminer des signaux VIDEO.

Sur la figure 1, on a représenté en plus des trois blocs 1, 2 et 3 représentant le limiteur 1, la bascule monostable 2 et le filtre passe bas 3, les formes d'ondes présentes en entrée et sortie de chacun de ces circuits. La valeur moyenne instantanée d'une grandeur électrique, $A_0$, par exemple une tension ou un courant obtenu en sortie du filtre passe bas 3, est sgate à :i

$$A_0 = E \, \tau \, f \text{ ou } A_0 = I.\tau\text{-f}$$

Dans ces expressions, E et I sont les valeurs prédéterminées des grandeurs électriques et f la valeur instantanée de la fréquence de l'onde modulée en fréquence que l'on veut démoduler.

Il convient de préciser à ce stade que la valeur moyenne instantanée d'un signal est le quotient de l'intégrale de l'amplitude du signal par rapport au temps, par le temps d'intégration de ce signal. Pour un signal périodique, cette valeur s'exprime par l'expression :

$$\frac{1}{T}\int_o^T f(t)dt$$

dans laquelle T est la période instantanée du signal et f(t) l'amplitude du signal en fonction du temps, mesurée entre les instants 0 et T.

Un deuxième dispositif connu utilise un limiteur disposant de deux sorties. Une ligne à retard, générant un retard $\tau$, est insérée dans l'une des sorties de l'étage limiteur. Un circuit "OU EXCLUSIF" (ou un étage mélangeur) reçoit sur l'une de ses entrées la sortie du limiteur et sur l'autre la sortie retardée. Ce circuit alimente ensuite un filtre passe bas. L'opération de logique combinatoire effectuée par le circuit "OU EXCLUSIF" se traduit par l'élaboration d'impulsions de durée $\tau = C^{te}$ ainsi que par un phénomène de doublement de la fréquence de récurrence des impulsions très intéressant, facilitant le calcul de la valeur moyenne effectuée par le filtre passe bas. Dans la mesure où la ligne à retard est très performante -ligne à retard réalisée à base de câbles coaxiaux ou de lignes micro-strip- il est possible en prenant par ailleurs de sévères précautions dans le traitement des impulsions de réaliser des démodulateurs de fréquence performants, mais une telle solution se prête mal à une intégration monolithique, en particulier pour les basses fréquences.

Pour des hautes fréquences de l'ordre de 100 MHz, on connaît d'un article intitulé "High-performance integrated receiver circuit for optical fiber transmission of wideband FM video signals", de L.P, de JONG et CMCJ HOOGHIEMSTRA, publié dans IEE Transaction on Consumer Electronics, volume CE-33 n° 3, août 1987, une solution dans laquelle la ligne à retard est réalisée sous une forme intégrable dans un ASIC.

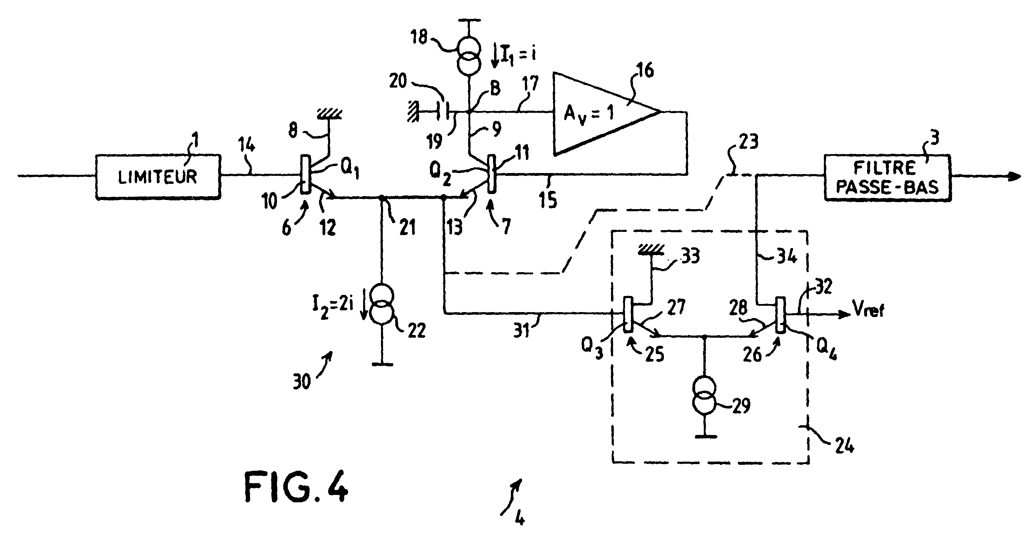

La réalisation d'une telle ligne à retard est décrite au paragraphe 3.3 de cet article en liaison avec la figure 4 de cet article. Fondamentalement, une pluralité de circuits tels que celui représenté figure 4 de cet article sont connectés en série. Chaque circuit apporte un retard $\tau_o$ en sorte que le retard total $\tau$ est égal à $n\tau_o$, n représentant le nombre de circuits.

Une telle réalisation est intéressante dans la mesure où elle peut être réalisée de façon monolithique mais l'on constate immédiatement que le retard $\tau$ est prédéterminé par le nombre de circuits élémentaires branchés en série et il n'est pas variable à la demande. Selon l'invention au contraire la valeur de $\tau$ peut être réglée pratiquement jusqu'à atteindre

$$\frac{T \min}{2}.$$

Tmin est la période de la fréquence la plus haute obtenue par la modulation. Cette caractéristique rend l'invention particulièrement intéressante pour des signaux large bande comportant en particulier des basses fréquences. Il a été vu plus haut que la valeur de $A_0$ est donnée par la relation $A_0 = E \, \tau \, f$, dans laquelle $\tau$ est le retard, E l'amplitude des impulsions produites, par exemple par le circuit monostable, et f la fréquence instantanée. La valeur de $A_0$ évolue donc entre deux valeurs $A_1 = E \, \tau \, fmin$ et $A_2 = E \, \tau \, fmax$. La dynamique de $A_0$ est donc égale à $A_2 - A_1 = E \, \tau \, (fmax - fmin)$. Aux basses fréquences porteuses, la différence entre fmax et fmin, qui est une fonction croissante de la fréquence porteuse, diminue. Par contre la valeur de $\tau$, qui selon l'invention peut aller jusqu'à

$$\frac{T \min}{2},$$

soit

$$\frac{1}{2f \max},$$

peut augmenter au point de compenser la diminution de $\Delta A_0 = A_2 - A_1$ due à la baisse de valeur de la fréquence porteuse.

La présente invention vise, comme la réalisation décrite dans l'article précité, un circuit démodulateur de fréquence intégrable dans un circuit intégré dédié. Le circuit selon l'invention fonctionne selon le principe de démodulation dans lequel une ligne à retard et un circuit "OU EXCLUSIF" sont utilisés. Toutefois, selon l'invention, un équivalent mathématique du retard $\tau$ est produit, mais sans qu'une ligne à retard soit utilisée.

L'invention part du constat que dans l'expression du coefficient $A_0 = E \tau f$, le coefficient $\tau$ a la dimension d'un temps. En conséquence, tout signal que l'on peut produire, et dont la valeur moyenne est proportionnelle à la fréquence, peut être utilisé pour démoduler un signal modulé en fréquence. Selon l'invention, un tel signal initial de démodulation est obtenu par une intégration par rapport au temps des fronts montant des impulsions en sortie du limiteur. Cette intégration est effectuée selon la formule

$$A_0 = \frac{E}{T} \int f(t)dt = \frac{E}{T} [\int_0^\tau \frac{t}{\tau}dt + \int_\tau^{T/2}dt],$$

soit

$$A_0 = E(\frac{1}{2} - \frac{\tau}{2T}) = \frac{E}{2} (1 - \tau f).$$

Dans ces expressions, t représente le temps écoulé à partir de chacun des fronts, par exemple montants, d'impulsions. Ainsi, selon l'invention, on utilise un circuit qui réalise, à partir des fronts des impulsions en sortie du limiteur, ces fronts ayant l'amplitude E, une intégration dissymétrique du signal présent en sortie du limiteur. Ainsi, l'invention est-elle relative à un circuit d'un démodulateur d'un signal modulé en fréquence, la fréquence instantanée du signal variant entre une fréquence minimum fmin et une fréquence maximum fmax, le circuit ayant au moins une entrée recevant un signal d'entrée formé par un train d'impulsions, chaque impulsion ayant un front montant et un front descendant, la hauteur d'une impulsion du signal d'entrée étant égale à la différence entre le niveau du signal avant un front montant ou descendant et son niveau après ce front montant ou descendant, le circuit produisant sur une sortie du circuit un signal dont l'intégrale instantanée par rapport au temps a une valeur proportionnelle à la fréquence instantanée des impulsions constituant le signal d'entrée, circuit caractérisé en ce qu'il réalise une intégration par rapport au temps de la hauteur d'au moins l'un des fronts de chaque impulsion du signal d'entrée du circuit.

Dans l'un des modes de réalisation qui sera décrit plus loin en référence à la figure 4, on utilise au moins un circuit dans lequel l'intégration sur le front de l'impulsion est obtenue par une charge linéaire d'une capacité. Le temps $\tau$ de charge de la capacité est alors un coefficient de proportionnalité entre la valeur instantanée du signal en sortie du filtre passe bas et la fréquence instantanée du signal modulé. Dans ce mode de réalisation, on utilise de préférence, en addition au circuit selon l'invention, un circuit générateur d'impulsions recevant le signal intégré en sortie du circuit selon ce premier mode de réalisation de l'invention et transformant ce signal en un train d'impulsions carrées ayant toutes la même largeur et dont la fréquence est égale ou multiple de la fréquence de l'onde modulée.

Ce mode de réalisation présente l'avantage de pouvoir utiliser des circuits bien connus de l'art antérieur. Il permet aussi de calibrer les impulsions de façon à s'affranchir par exemple des dérives d'amplitudes dues à des variations de température.

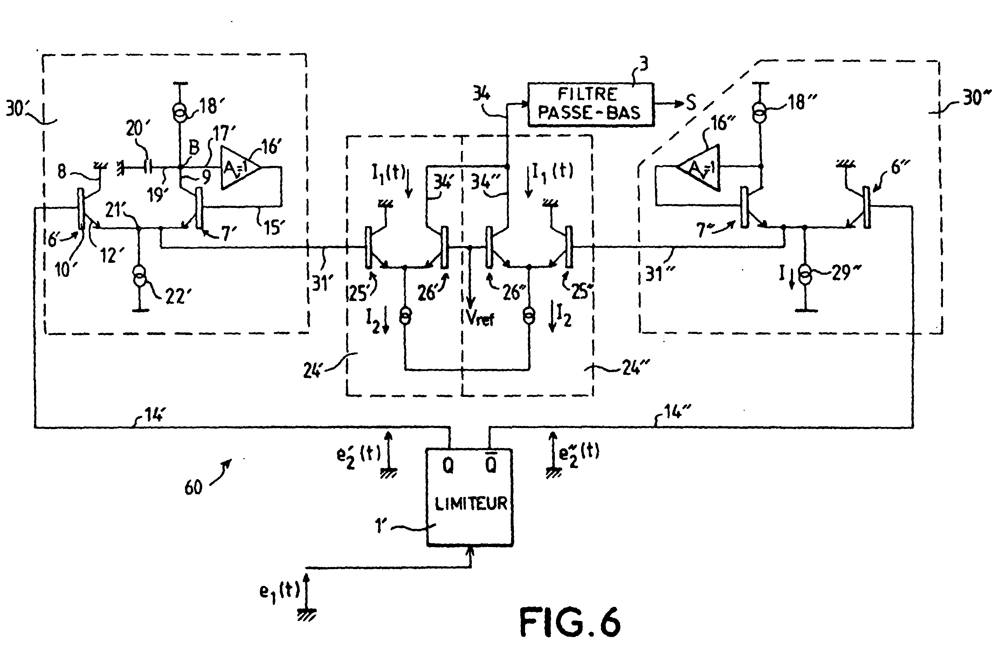

Dans le mode préféré de réalisation qui sera décrit plus loin en référence à la figure 6, on utilise deux circuits selon l'invention de façon à bénéficier de l'effet de doublement de la fréquence des impulsions.

Le mode le plus général de réalisation de l'invention, des modes de réalisation de celle-ci, ainsi qu'un mode préféré de réalisation seront ci-après décrits et leurs fonctionnements expliqués, cela à titre d'exemple nullement limitatif, en regard des dessins annexés dans lesquels :

- La figure 1, déjà décrite, représente un circuit de démodulation d'un signal modulé en fréquence selon un art antérieur connu.
- La figure 2 représente un schéma expliquant le mode d'insertion de l'invention dans un démodulateur et destiné à décrire l'invention sous sa forme la plus générale.
- La figure 3 comporte les figures 3.1 à 3.3. Il s'agit de courbes représentant sur une même échelle des temps l'amplitude de différents signaux.
- La courbe 3.1 représente la forme d'un signal $e_1(t)$ présent en entrée d'un circuit limiteur qui est le circuit d'entrée d'un démodulateur.
- La courbe 3.2 représente la forme du signal $e_2(t)$, qui est le transformé du signal $e_1(t)$ par le circuit limiteur.
- La courbe 3.3 représente la forme d'un signal $e_4(t)$ présent en sortie d'un circuit intégrateur dissymétrique selon l'invention, ce circuit recevant en entrée le signal $e_2(t)$ présent à la sortie d'un circuit limiteur.
- La figure 4 représente un premier exemple de réalisation d'un circuit réalisant une intégration dissymétrique d'un front d'impulsions présentes en sortie du circuit limiteur ainsi qu'une variante avantageuse de réalisation.

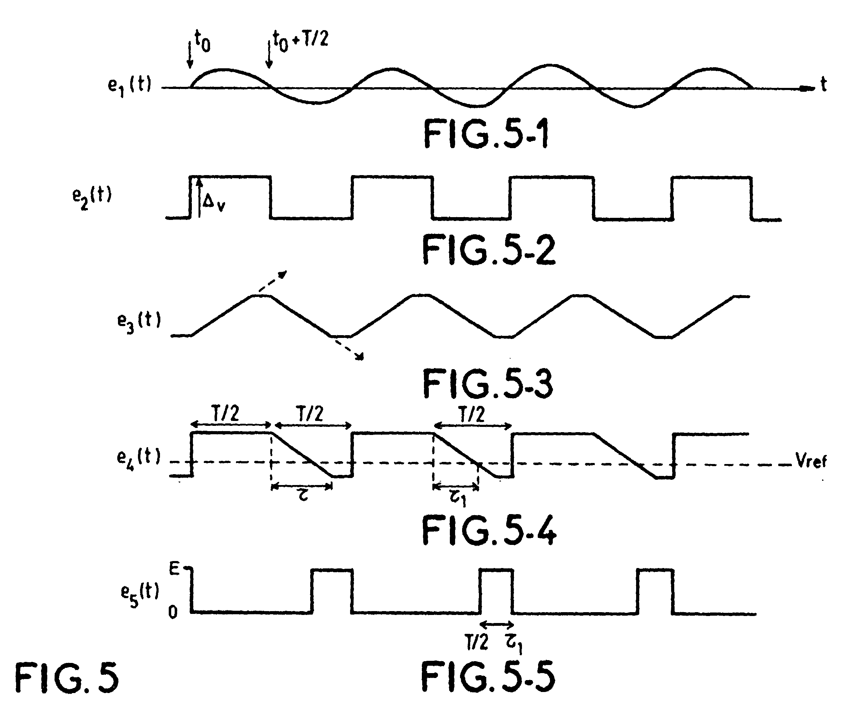

- La figure 5 comporte les figures 5.1 à 5.5. Il s'agit de courbes représentant sur une même échelle de temps :

- Pour la figure 5.1, la forme d'une onde à démoduler présente en entrée du circuit limiteur.
- Pour la figure 5.2, un train d'impulsions de durées variables présent en sortie du circuit limiteur.
- Pour la figure 5.3, la forme d'un signal présent en un point du circuit décrit figure 4.
- Pour la figure 5.4, la forme d'un signal en sortie du circuit selon le premier mode de réalisation décrit en liaison avec la figure 4.
- Pour la figure 5.5, la forme d'un signal en sortie d'un circuit selon la variante avantageuse de réalisation décrite en liaison avec la figure 4.
- La figure 6 représente le mode préféré de réalisation de l'invention.

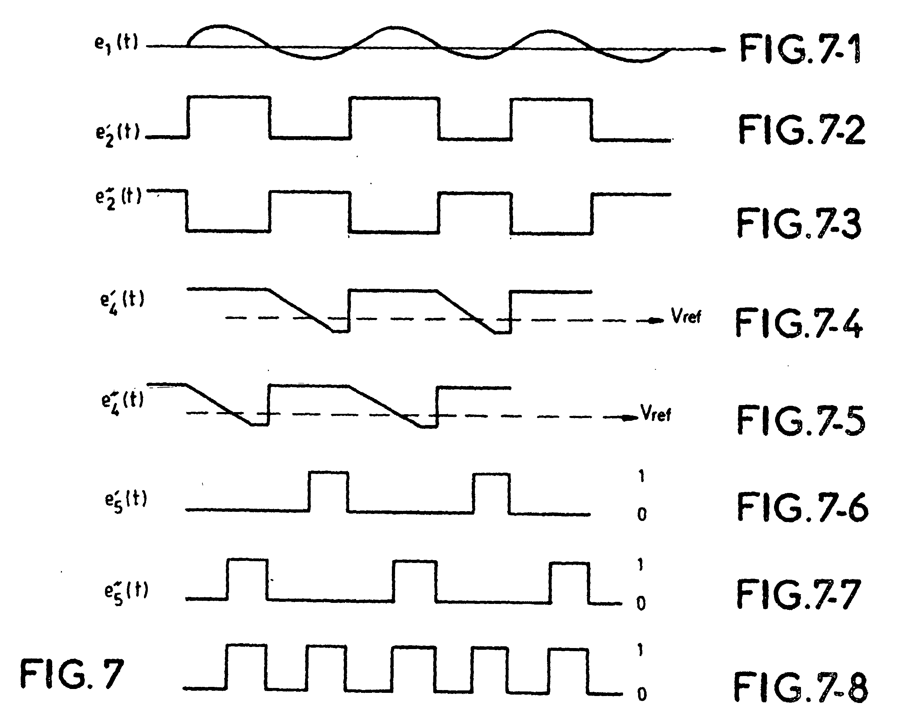

- La figure 7 comprend les figures 7.1 à 7.8. Il s'agit de courbes représentant sur une même échelle de temps :

- Pour la figure 7.1, la forme d'une onde à démoduler présente en entrée du circuit limiteur.
- Pour les figures 7.2 et 7.3, la forme respectivement d'un premier et d'un second train d'impulsions présents en sortie du circuit limiteur.
- Pour les figures 7.4 et 7.5, la forme du signal présent en sortie de deux circuits selon l'invention telle que réalisée selon le premier mode de réalisation.
- Pour les figures 7.6 et 7.7, la forme du signal présent en sortie de deux circuits selon l'invention telle que réalisée selon la variante avantageuse de réalisation.
- Pour la figure 7.8, la forme du signal présent en sortie du circuit réalisant une intégration dissymétrique selon le mode préféré de réalisation de l'invention.

Pour une première approche dans la compréhension du principe de fonctionnement du démodulateur selon l'invention, ce dernier sera explicité en liaison avec les figures 2 et 3.

La figure 2 représente schématiquement l'emplacement du circuit selon l'invention par rapport aux circuits de l'art antérieur.

Le circuit intégrateur dissymétrique 4 selon l'invention se situe, comme par exemple la bascule monostable 2 de l'art antérieur, entre un circuit limiteur 1 et un filtre passe bas 3. Le circuit limiteur 1 reçoit en entrée un signal $e_1(t)$, représenté figure 3.1, qui est l'onde modulée en fréquence que l'on veut démoduler. A partir de cette onde, le circuit limiteur produit de façon connue un signal $e_2(t)$, représenté figure 3.2, formé par une succession de niveaux bas et hauts. Un front montant est produit chaque fois que le signal $e_1(t)$ passe par 0 avec une dérivée positive. Un front descendant est produit chaque fois que le signal $e_1(t)$ passe par 0 avec une dérivée négative.

Selon un mode de réalisation de l'invention, l'intégrateur dissymétrique va produire un signal $e_4(t)$ représenté figure 3.3, qui a pour caractéristique que sa valeur moyenne instantanée est proportionnelle à la valeur absolue de la fréquence instantanée du signal $e_1(t)$ à démoduler. C'est ce signal qui comme dans l'art antérieur, va être introduit dans le filtre passe bas 3 pour produire le signal $A_0$.

Un exemple de réalisation d'un circuit intégrateur réalisant l'intégration dissymétrique selon la formule :

$$A_0 = \frac{E}{T} \left[ \int_0^{\tau 0} \frac{t}{\tau} dt + \int_\tau^{T/2} dt \right]$$

va être ci-après décrit en liaison avec les figures 4 et 5.

Sur la figure 4, l'exemple de réalisation de circuit intégrateur 4 est toujours représenté entre un circuit limiteur 1 et un filtre passe bas 3.

La figure 5 représente sur une même échelle des temps les formes de signaux présents en différents points du circuit représenté figure 4. Les signaux $e_1(t)$ et $e_2(t)$, présents en entrée et sortie du circuit limiteur 1 font l'objet des figures 5.1 et 5.2 respectivement. Ils ont été reproduits figure 5 pour faire apparaître les synchronies de ces signaux avec les différents signaux qui apparaissent dans le circuit intégrateur dissymétrique 4.

Le circuit représenté figure 4 comporte une structure différentielle modifiée 30 formée, par exemple, par deux transistors $Q_1$ 6 et $Q_2$ 7. Ces transistors comportent chacun un collecteur 8 et 9 respectivement, une base 10 et 11 respectivement et un émetteur 12 et 13 respectivement.

La description qui va suivre est effectuée pour des transistors NPN, l'homme du métier pourra aisément adapter le circuit à l'emploi des transistors PNP.

Les deux entrées de la structure différentielle 30 sont constituées par les raccordements 14 et 15 aux bases 10 et 11 de chacun des transistors $Q_1$ 6 et $Q_2$ 7. Le premier raccordement 14 du transistor $Q_1$ 6 reçoit le signal $e_2(t)$ en provenance du limiteur 1. Le second raccordement 15 de la structure différentielle modifiée 30 reçoit la sortie d'un étage séparateur de gain unitaire 16 dont l'entrée 17 est connectée d'une part à un générateur de courant 18 et à une borne 19 d'une capacité 20 et d'autre part à la borne 9 de $Q_2$ 7. C'est en raison de la présence des éléments 16, 18 et 20 que la structure différentielle 30, qui au sens strict ne comporte que les transistors $Q_1$ 6 et $Q_2$ 7, a été appelée structure différentielle modifiée. La capacité 20 peut ne pas avoir d'existence physique, en particulier à haute fréquence, car il peut s'agir d'une capacité parasite, c'est-à-dire une capacité que forment entre eux des éléments de circuit. La capacité 20 fait de préférence partie du circuit intégré spécifique comportant le circuit selon l'invention. Elle peut cependant être extérieure à ce circuit. Le générateur de courant 18 délivre un courant $I_1$ en direction du

point de raccordement commun B de la borne 19 de la capacité 20, du générateur de courant 18, et de l'entrée 17 de l'étage séparateur de gain unitaire 16. La sortie 21 de la structure différentielle modifiée 30 est constituée par un point commun 21 aux émetteurs 12 et 13 des transistors $Q_1$ 6 et $Q_2$ 7. Un générateur de courant 22 est connecté au point commun 21. Il délivre un courant d'intensité $I_2$ double de celui $I_1$ du générateur de courant 18. La structure différentielle modifiée 30 est composée des éléments référencés 6 à 22.

Le fonctionnement de la structure différentielle modifiée 30 sera ci-après expliqué. Le raccordement 14 de cette structure différentielle modifiée 30 est équivalent à l'entrée $e^{(+)}$ d'un système bouclé dont le raccordement 15 constitue l'entrée $e^{(-)}$. Il est bien connu que dans un tel système, l'entrée $e^{(-)}$ tend à recopier fidèlement -si rien ne s'y oppose- le signal appliqué sur le raccordement $e^{(+)}$ 14. Supposons qu'à un instant to-$\varepsilon$, le raccordement $e^{(-)}$ 15 recopie rigoureusement le potentiel appliqué sur le raccordement $e^{(+)}$ 14. Dans une telle hypothèse, le courant $I_2 = 2I_1$ du générateur de courant 22 se répartit équitablement dans les transistors $Q_1$ 6 et $Q_2$ 7.

Le courant de collecteur 9 $I_{(c)}$ du transistor $Q_2$ 7 est égal au courant d'émetteur $I_E$ de ce même transistor. Ainsi, le courant $I_1$ du générateur de courant 18 est "absorbé" par le collecteur 9 du transistor $Q_2$ 7.

On suppose qu'en $t_0$ apparaît une transition positive $\Delta V$ sous la forme d'un front montant du signal $e_2(t)$ en sortie du circuit limiteur 1. Cette transition apparaît sur le raccordement $e^{(+)}$ 14 de la structure différentielle modifiée 30. Cette transition est de façon connue recopiée sur l'émetteur 12 du transistor $Q_1$ 6, ce dernier n'étant autre qu'un étage suiveur. En raison de la présence de la capacité 20, le raccordement $e^{(-)}$ 15 ne peut recopier instantanément le potentiel appliqué au raccordement $e^{(+)}$ 14. Le raccordement $e^{(-)}$ 15 reste momentanément au niveau bas qu'il avait avant $t_0$. Le transistor $Q_2$ 7 est bloqué sous l'effet de la transition positive $\Delta V$ appliquée entre son émetteur 13 et sa base 11. Le transistor $Q_2$ 7 étant bloqué, le courant $I_2 = 2I_1$ est intégralement dérivé vers l'émetteur 12 du transistor $Q_1$ 6. La valeur du courant de collecteur 9 $I_{(c)}$ du transistor $Q_2$ 7 étant nulle, le courant $I_1$ est "injecté" dans la capacité 20, cette dernière se charge linéairement vers une tension positive. La variation de tension développée aux bornes de la capacité 20 est transmise sur le raccordement $e^{(-)}$ 15 via l'étage séparateur de gain unitaire 16.

Au bout d'un temps

$$\tau = \frac{C\Delta V}{I_1},$$

, avec

$$\tau \leq \frac{Tmin}{2} = \frac{1}{2f\,max},$$

le raccordement $e^{(-)}$ 15 de la structure différentielle modifiée 30 recopie le potentiel appliqué sur le raccordement $e^{(+)}$ 14. Le courant $I_2 = 2I_1$ se répartit à nouveau symétriquement dans les transistors $Q_1$ 6 et $Q_2$ 7, ce qui annule le courant de charge de la capacité 20.

A l'instant

$$t_0 + \frac{T}{2},$$

une transition négative $\Delta V$, correspondant au front descendant du signal $e_2(t)$ est appliquée sur le raccordement $e^{(+)}$ 14 de la structure différentielle modifiée 30. En raison du type de transistor utilisé et du phénomène de recopie de la tension mémorisée par la capacité 20 sur l'émetteur 13 du transistor $Q_2$ 7 via l'étage séparateur de gain unitaire 16, le transistor $Q_1$ 6 est porté au blocage. Le courant $I_2 = 2I_1$ du générateur de courant 22 est intégralement dérivé vers l'émetteur 13 du transistor $Q_2$ 7. La valeur du courant de collecteur 9 $I_c$ du transistor $Q_2$ 7 est sensiblement égale à la valeur $I_E$ du courant d'émetteur de ce même transistor. Le générateur de courant 18 ne délivrant qu'un courant $I_1$, cela signifie que le complément de courant est fourni par un courant égal à $I_1$, également en provenance de la capacité 20. La capacité 20 se décharge avec un courant $I_1$ vers des tensions négatives. La variation de tension aux bornes de la capacité 20 est fidèlement transmise d'une part sur la base 11 du transistor $Q_2$ 7 par le raccordement $e^{(-)}$ 15 et d'autre part sur l'émetteur 13 du transistor $Q_2$ 7.

Au bout d'un temps

$$\tau = \frac{C\Delta V}{I_1},$$

le raccordement $e^{(-)}$ 15 atteint le potentiel appliqué sur le raccordement $e^{(+)}$ 14. La boucle de contre réaction redevient opérationnelle. La structure différentielle modifiée 30 se stabilise à nouveau à l'équilibre. La valeur du courant collecteur 9 $I_c$ du transistor $Q_2$ 7 devient égale à $I_1$. Le courant de décharge de la capacité 20 s'annule. Le cycle est terminé.

La valeur de la tension $e_3(t)$ disponible respectivement entre la masse et le point de connexion commun B 19 à la capacité 20, au générateur de courant 18 et à l'entrée 17 de l'étage séparateur 16 est représentée figure 5.3. Celle de la tension $e_4(t)$ présente entre la masse et la sortie 21 de la structure différentielle modifiée 30 est représentée figure 5.4.

La courbe représentant $e_3(t)$ comporte une montée linéaire pendant un temps $\tau$ égal au temps de charge de la capacité 20, un palier pendant le temps T/2 - $\tau$ correspondant au temps pendant lequel la structure différentielle modifiée 30 recopie sur son raccordement $e^{(-)}$ 15 le signal présent en raccordement $e^{(+)}$ 14. Elle comporte enfin une descente linéaire pendant le temps $\tau$ correspondant au temps de décharge de la capacité 20 sous un courant égal à $I_1$. Ainsi, la constante $\tau$ est réglée par les valeurs de $I_1$ et de C.

Au signe près, la loi de variation du signal $e_4(t)$ disponible sur les émetteurs 12 et 13 des transistors $Q_1$-6 et $Q_2$-7 est rigoureusement identique à celle du signal représenté figure 3.3 pour décrire le principe de démodulation de fréquence proposé. La sortie 21 portant ce signal est comme dans l'art antérieur, connectée à l'entrée du filtre passe bas 3 par une liaison 23 représentée en pointillés.

Dans une variante avantageuse de réalisation, le signal $e_4(t)$ n'est pas appliqué directement au filtre passe bas 3. Il y est appliqué par l'intermédiaire d'un commutateur de courant 24.

La fonction du commutateur de courant 24 est de convertir le signal $e_4(t)$ présent en sortie 21 des émetteurs 12 et 13 en un signal impulsionnel à impulsions carrées dont le filtrage donnera la valeur $A_0$. L'intérêt de cette conversion est double. D'une part, il permet d'éliminer un décalage (offset) continu négatif dont est affecté le signal $e_4(t)$. Ce décalage augmente l'amplitude du signal continu traité par le filtre passe bas et donc rend plus difficile le traitement sans aucun avantage par ailleurs. D'autre part, il permet au passage de s'affranchir des variations de l'amplitude E de la partie utile du signal $e_4(t)$. Ces variations peuvent être par exemple dues à des dérives en température. Un exemple de réalisation et le mode de fonctionnement du commutateur de courant 24 seront ci-après décrits en liaison avec la figure 4.

Le signal $e_4(t)$ est appliqué sur une entrée d'un commutateur de courant 24, par exemple à structure différentielle comportant deux transistors $Q_3$ 25 et $Q_4$ 26 dont les émetteurs 27 et 28 respectivement sont connectés l'un à l'autre. La connexion commune des émetteurs 27 et 28 est connectée à une source de courant 29 délivrant un courant $I_3$.

La base 31 du transistor $Q_3$ 25 reçoit le signal $e_4(t)$. La base 32 du transistor $Q_4$ 26 est connectée à une source de tension de référence $V_{ref}$ dont la valeur doit être supérieure au niveau bas du signal $e_4(t)$ et inférieure au niveau haut. Le collecteur 33 du transistor $Q_3$ 25 est raccordé par exemple à la masse. Le collecteur 34 du transistor $Q_4$ 26 est raccordé au filtre passe bas 3.

Le fonctionnement est le suivant. Tant que la tension appliquée à la base du transistor $Q_3$ 25 est inférieure à la tension $V_{ref}$, le courant $I_3$ est commuté vers le filtre passe bas 3 par le transistor $Q_4$ 26 car le transistor $Q_3$ 25 est bloqué. Quand la tension appliquée à la base 31 du transistor $Q_3$ 25 devient supérieure à la tension de référence $V_{ref}$, le transistor $Q_3$ 25 est conducteur. Le courant $I_3$ est commuté dans le transistor $Q_3$ 25. Le transistor $Q_4$ 26 est bloqué.

Ainsi, on injecte dans le filtre passe bas 3 des impulsions de courant caractérisées par une amplitude égale à $I_3$ et une durée égale à

$$\frac{T}{2} - \tau_1,$$

où

$\tau_1$ est le temps que met le signal $e_4(t)$ pour évoluer de son niveau haut à la valeur $V_{ref}$.

On démontre que la valeur moyenne des impulsions de courant ainsi produites est proportionnelle à la valeur moyenne du signal $e_4(t)$, donc à la valeur de la fréquence à démoduler. Le signal $e_5(t)$ présent à l'entrée du filtre passe bas 3 alimenté par le collecteur 34 du transistor $Q_4$ 26 est représenté figure 5.5. Il s'agit d'un train d'impulsions. Chaque impulsion du train a une durée égale à

$$\frac{T}{2} - \tau_1.$$

Leur fréquence est proportionnelle à la fréquence instantanée du signal à démoduler.

Le mode préféré de réalisation de l'invention sera maintenant décrit et son fonctionnement expliqué en référence aux figures 6 et 7.

La figure 6 représente un exemple de schéma électrique d'un circuit 60 selon l'invention. La figure 7 représente sur une même échelle de temps la forme de signaux présents en divers points du circuit électrique représenté figure 6. Elle comprend les figures 7.1 à 7.8.

Le circuit représenté figure 6 est, comme celui représenté figure 4, un circuit recevant un signal $e_2(t)$ en sortie d'un limiteur 1' recevant un signal à démoduler $e_1(t)$. Le limiteur 1' à employer avec le circuit 60 a deux sorties symétriques, une première 14' et une seconde 14". Les signaux présents sur la première sortie sont des impulsions positives $e'_2(t)$, comme celle qui ont été décrites plus haut en liaison avec la figure 3.2. Les signaux $e''_2(t)$ présents sur la seconde sortie 14" sont des impulsions symétriques de celles du signal $e'_2(t)$. On veut dire par "symétrique" que les impulsions du signal $e''_2(t)$ ont leurs points de valeur basse pendant que le signal $e'_2(t)$ a ses points de valeur haute. Il n'est pas important que les différences entre la valeur basse et la valeur haute des signaux $e'_2(t)$ et $e''_2(t)$ soient égales l'une à l'autre. Il se trouve que dans l'exemple de réalisation ici décrit, cela est le cas. Les signaux $e_1(t)$, $e'_2(t)$ et $e''_2(t)$ font l'objet des figures 7.1 à 7.3 respectivement.

La sortie 34 du circuit 60 est, comme dans l'exemple décrit en relation avec la figure 4 connectée à un filtre passe-bas 3.

Le circuit 60 sera maintenant décrit. Ce circuit comprend deux structures différentielles modifiées 30' et 30". Les structures différentielles modifiées 30' et 30" comportent les mêmes éléments raccordés de la même façon. Ces éléments sont les mêmes et raccordés entre eux de la même façon que le circuit décrit en relation avec la figure 4 et portant la référence 30. Sur la figure 6, on a repris pour les structures différentielles modifiées 30' et 30" les mêmes numéros de référence que ceux utilisés pour décrire la structure différentielle modifiée 30 de la figure 4 avec des exposants ' et ". La structure différentielle modifiée 30' de la figure 6 occupe la partie gauche de la figure. La structure différentielle modifiée 30" occupe la partie droite de la figure 6.

La structure différentielle modifiée 30' est connectée à la première sortie 14' du limiteur 1'. La structure différentielle modifiée 30" est connectée à la seconde sortie 14" du limiteur 1'. Les sorties 31' et 31 " des structures différentielles modifiées 30' et 30" pourraient être raccordées entre elles et alimenter le filtre passe bas 3. De façon avantageuse, chacune des sorties 31' et 31 " est raccordée à un commutateur de courant 24' et 24" respectivement.

Chacun des commutateurs de courant 24' et 24" comporte les mêmes éléments raccordés entre eux de la même façon que ceux du commutateur de courant 24 décrit en relation avec la figure 4. En conséquence, les éléments des commutateurs de courant 24' et 24" portent les mêmes numéros de référence que ceux de leur homologue de la figure 4.

Chacune des sorties 31' et 31" des structures différentielles modifiées 30' et 30" alimente une entrée des commutateurs de courant 24' et 24". Les collecteurs 34' et 34" des commutateurs de courant 24' et 24" sont raccordées entre eux et alimentent le filtre passe bas 3.

Le fonctionnement détaillé et la description détaillée des structures différentielles modifiées 30' et 30", des commutateurs de courant 24' et 24" composant le circuit 60 ne sera pas repris. Le lecteur est renvoyé à la description de la structure différentielle modifiée 30 et du commutateur de courant 24 effectuée en liaison avec la figure 4.

L'intérêt de cette structure double sera maintenant explicité en liaison avec les figures 7.4 à 7.8. Les figures 7.4 et 7.5 représentent respectivement la forme des signaux en sortie 31' de la structure différentielle modifiée 30' et en sortie 31" de la structure différentielle modifiée 30".

La symétrie des signaux $e'_2(t)$ et $e"_2(t)$ en entrée 14' et 14" de chacun de ces circuits provoque un décalage d'une demi-période dans la forme des signaux $e'_4(t)$ et $e"_4(t)$ présents en sorties 31' et 31" des structures différentielles modifiées 30' et 30". Ce décalage apparaît lorsqu'on compare les courbes représentées figures 7.4 et 7.5 respectivement.

Du fait de ce décalage, il apparaît également un décalage égal à une demi-période de la fréquence modulée $e_1(t)$ présente en entrée du circuit 60, entre les collecteurs 34' et 34" des commutateurs de courant 24' et 24". Les signaux $e'_5(t)$ et $e"_5(t)$ présents dans les collecteurs 34' et 34" des commutateurs de courant 24' et 24" sont eux aussi décalés dans le temps l'un par rapport à l'autre d'une demi-période. Ils sont représentés figures 7.6 et 7.7.

Le signal dans le collecteur 34 de la double structure 24' et 24" est composé de l'addition des signaux $e'_5(t)$ et $e"_5(t)$ présents dans les collecteurs 34' et 34". On a ainsi en sortie du circuit 60 des impulsions représentées figure 7.8 dont la fréquence est double de la fréquence instantanée présente en entrée du circuit 60. L'intérêt de ce doublement est connu de l'homme du métier. Il sera rappelé ci-après.

D'une part, il augmente d'un facteur 2 l'amplitude du signal détecté en sortie du circuit passe bas 3, mais d'autre part, et surtout, il double la fréquence de base et donc la fréquence du premier harmonique de cette fréquence doublée. Il en résultera une plus grande facilité à construire le filtre passe bas 3.

Le circuit selon l'invention présente l'avantage de pouvoir être entièrement réalisé sur un circuit intégré dédié. Toutefois, dans quelques cas, en particulier si la valeur de la capacité 20 est importante, il pourra être intéressant de construire le circuit en prévoyant des bornes de raccordement à une ou plusieurs capacités 20 ou 20' ou 20".

Il y aura une capacité 20 si le circuit est réalisé selon le mode décrit en relation avec la figure 4.

Il y aura deux capacités 20', 20" si le circuit est réalisé selon le mode décrit en relation avec la figure 6. Dans ce cas, le circuit intégré et le ou les capacités formeront ensemble le circuit selon l'invention.

## Revendications

1.  Circuit (30, 24, 60, 24', 24") d'un démodulateur d'un signal modulé en fréquence instantanée du signal variant entre une fréquence minimum fmin et une fréquence maximum fmax, le circuit ayant au moins une entrée (14, 14', 14") recevant un signal d'entrée formé par un train d'impulsions, chaque impulsion ayant un front montant et un front descendant, la hauteur d'une impulsion du signal d'entrée étant égale à la différence entre le niveau du signal avant un front montant ou descendant et son niveau après ce front montant ou descendant, le circuit (30, 24, 60, 24', 24") produisant sur une sortie (21, 34) du circuit un signal dont l'intégrale instantanée par rapport au temps a une valeur proportionnelle à la fréquence instantanée des impulsions constituant le signal d'entrée, circuit **caractérisée en ce qu'**il réalise une intégration par rapport au temps de la hauteur d'au moins l'un des fronts de chaque impulsion du signal d'entrée du circuit, le temps d'intégration de la hauteur de chaque front intégré étant un temps $\tau$ au plus égal à ½ fmax.

2.  Circuit selon la revendication 1 (30, 24, 60, 24', 24") **caractérisé en ce qu'**il comporte une capacité (20) dont la charge à courant constant pendant le temps $\tau$ réalise l'intégration du front intégré.

**3.** Circuit (30, 24, 60, 24', 24") selon la revendication 2, **caractérisé en ce qu'**il comporte au moins une structure différentielle modifiée (30), la structure comportant au moins deux éléments actifs (6, 7) montés de façon symétrique, chaque élément actif ayant au moins une connexion, l'une des connexions (15) d'un élément actif (7) recevant la sortie d'un étage séparateur de gain unitaire (16) ayant une entrée (17), cette entrée (17) étant connectée à un point B (19) auquel sont également connectés une borne de la capacité (20) d'intégration et un générateur de courant constant (18);

**4.** Circuit (30, 24, 60, 24', 24") selon la revendication 3, **caractérisé en ce que** les deux éléments actifs sont deux transistors (6, 7), un premier (6) et un second (7), chaque transistor (6, 7) ayant un émetteur (12, 13), un collecteur (8, 9) et une base (10, 11).

**5.** Circuit (30, 24, 60, 24', 24") selon la revendication 4, **caractérisé en ce que** la connexion (15) recevant la sortie de l'étage séparateur de gain unitaire (16) est le collecteur (19) de l'un des transistors (7).

**6.** Circuit (30, 24, 60, 24', 24") selon l'une des revendications 4 ou 5, **caractérisé en ce que** les émetteurs (12, 13) de chacun des transistors (6, 7) sont connectés entre eux en un point (21) auquel et raccordé un générateur de courant (22).

**7.** Circuit (30, 24, 60, 24', 24") selon la revendication 6, **caractérisé en ce que** le point commun (21) de connexion des émetteurs (12, 13) de chacun des émetteurs constitue la sortie (21) du circuit (30, 60).

**8.** Circuit (30, 24, 60, 24', 24") selon la revendication 6, **caractérisé en ce que** le circuit (30) comporte en outre un commutateur de courant (24) ayant une entrée (31), une sortie (32), l'entrée (31) du commutateur de courant (24) étant connectée au point commun aux émetteurs (12, 13) des transistors (6, 7) et la sortie (34) du commutateur de courant (24) constituant la sortie du circuit (30, 24).

**9.** Circuit (30, 24, 60, 24', 24") selon la revendication 8, **caractérisé en ce que** le commutateur de courant (24) comporte une structure différentielle composée de deux éléments actifs (25, 26) branchés de façon symétrique.

**10.** Circuit (30, 24, 60, 24', 24") selon la revendication 9, **caractérisé en ce que** les deux éléments actifs (25, 26) du commutateur de courant (24) sont deux transistors (25, 26) ayant chacun une base (31, 32), un collecteur (33, 34), et un émetteur (27, 28).

**11.** Circuit (30, 24, 60, 24', 24") selon la revendication 10, **caractérisé en ce que** les collecteurs (27, 28) des transistors (25, 26) du commutateur de courant (24) sont raccordés entre eux, leur connexion commune étant raccordée à un générateur de courant (29).

**12.** Circuit (30, 24, 60, 24', 24") selon la revendication 11, **caractérisé en ce que** l'entrée (31) du commutateur de courant (24) se fait sur la base (31) de l'un des transistors (25), la sortie sur le collecteur (34) de l'autre transistor (26), la base (32) de cet autre transistor (26) recevant une tension de référence.

**13.** Circuit (30, 24, 60, 24', 24"), **caractérisé en ce qu'**il comporte deux structures différentielles, selon l'une des revendications 3 à 8, chacune des deux structures ayant les mêmes éléments que l'autre, branchés de la même façon, chaque structure (30', 30") ayant une entrée et les sorties de chacune des structures (21', 21") étant raccordées l'une à l'autre.

**14.** Circuit (30, 24, 60, 24', 24") selon l'une des revendications 8 à 12, **caractérisé en ce qu'**il comporte deux circuits (30', 30", 24', 24"), chacun des deux circuits ayant les mêmes éléments que l'autre branchés de la même façon, chaque circuit ayant une entrée (14', 14"), les sorties (34', 34") de chacun des circuits (30', 30", 24', 24") étant raccordées l'une à l'autre.

**15.** Circuit intégré comportant un circuit selon l'une des revendications 1 à 14.

**16.** Circuit intégré et capacité (20) formant ensemble un circuit selon l'une des revendications 1 à 14.

**17.** Démodulateur d'un signal modulé en fréquence ayant un circuit limiteur (1) muni d'une entrée recevant le signal modulé en fréquence et produisant sur au moins une sortie (14, 14', 14") un train d'impulsions dont la fréquence d'occurence est une fonction de la fréquence instantanée du signal d'entrée, d'un filtre passe-bas (3) ayant une sortie et une entrée, la sortie portant un signal représentant la modulation portée par le signal modulé en fréquence, démodulateur **caractérisé en ce qu'**il comporte un circuit selon l'une des revendications 1 à 14, ce circuit recevant le train d'impulsions en sortie (14, 14', 14") du circuit limiteur (1) et alimentant le filtre passe-bas (3).

**18.** Démodulateur selon la revendication 17, **caractérisé en ce qu'**il est réalisé sur un circuit intégré.

**19.** Démodulateur, **caractérisé en ce qu'**il est réalisé pour partie sur un circuit intégré, cette partie et au moins une capacité connectée à cette partie formant ensemble un démodulateur selon la revendication 17.

**Patentansprüche**

1. Demodulatorschaltung (30, 24, 60, 24', 24") für ein Signal, das durch die Augenblicksfrequenz des Signals frequenzmoduliert ist, das sich zwischen einem Frequenzminimum fmin und einem Frequenzmaximum fmax ändert, wobei die Schaltung wenigstens einen Eingang (14, 14', 14") aufweist, der ein Eingangssignal aus einer Impulsfolge empfängt, wobei jeder Impuls eine Anstiegsflanke und eine Abfallflanke aufweist und die Höhe eines Impulses des Eingangssignals gleich der Differenz zwischen dem Signalwert vor einer Anstiegsflanke oder Abfallflanke und ihr Wert nach der Anstiegsflanke oder Abfallflanke ist, wobei die Schaltung (30, 24, 60, 24', 24") an einem Ausgang (21, 34) der Schaltung ein Signal erzeugt, dessen augenblickliches Integral über die Zeit bei einem Wert proportional zu der Augenblicksfrequenz der das Eingangssignal darstellenden Impulse ist,
   **dadurch gekennzeichnet, dass**
   die Schaltung eine Integration über die Zeit der Höhe wenigstens einer der Flanken jedes Impulses des Eingangssignals der Schaltung aufweist und die Integrationszeit der Höhe jeder integrierten Flanke eine Zeit $\tau$ und höchstens gleich 1/2 fmax beträgt.

2. Schaltung (30, 24, 60, 24', 24") nach Anspruch 2, **gekennzeichnet durch** eine Kapazität (20), deren Ladestrom während der Zeit $\tau$ die Integration der integrierten Flanke bildet.

3. Schaltung (30, 24, 60, 24', 24") nach Anspruch 2, **gekennzeichnet durch** wenigstens einen modifizierten differenziellen Aufbau (30), dass der Aufbau wenigstens zwei aktive Elemente (6, 7) in einer symmetrischen Anordnung enthält, jedes aktive Element wenigstens einen Anschluss aufweist, einer der Anschlüsse (15) eines aktiven Elements (7) den Ausgang einer Trennstufe mit der Verstärkung eins (16) empfängt, die einen Eingang (17) ent-hält, wobei dieser Eingang (17) mit einem Punkt B (19) verbunden ist, mit dem außerdem ein Anschluss der Kapazität (20) zur Integration und ein Konstantstromgenerator (18) angeschlossen sind.

4. Schaltung (30, 24, 60, 24', 24") nach Anspruch 3, **dadurch gekennzeichnet, dass** die beiden aktiven Elemente zwei Transistoren (6, 7), ein erster (6) und ein zweiter (7) sind, dass jeder Transistor (6, 7) einen Emitter (12, 13), einen Kollektor (8, 9) und eine Basis (10, 11) aufweist.

5. Schaltung (30, 24, 60, 24', 24") nach Anspruch 4, **dadurch gekennzeichnet, dass** die Verbindung (15), die den Ausgang der Trennstufe mit der Verstärkung eins (16) und dem Kollektor (19) eines der Transistoren (7) empfängt.

6. Schaltung (30, 24, 60, 24', 24") nach einem der Ansprüche 4 oder 5, **dadurch gekennzeichnet, dass** die Emitter (12, 13) jedes der Transistoren (6, 7) miteinander an einem Punkt (21) verbunden sind, an den ein Stromgenerator (22) angeschlossen ist.

7. Schaltung (30, 24, 60, 24', 24") nach Anspruch 6, **dadurch gekennzeichnet, dass** der gemeinsame Verbindungspunkt: (21) der Emitter (12,13) jedes der Emitter den Ausgang (21) der Schaltung (30, 60) darstellt.

8. Schaltung (30, 24, 60, 24', 24") nach Anspruch 6, **dadurch gekennzeichnet, dass** die Schaltung (30) außerdem einen Stromumschalter (24) mit einem Eingang (31), einem Ausgang (32) aufweist, und der Eingang (31) des Stromumschalters (24) an einem gemeinsamen Punkt mit den Emittern (12, 13) der Transistoren (6, 7) verbunden ist und der Ausgang (34) des Stromumschalters (24) den Ausgang der Schaltung (30, 24) bildet.

9. Schaltung (30, 24, 60, 24', 24") nach Anspruch 8, **dadurch gekennzeichnet, dass** der Stromumschalter (24) einen differenziellen Aufbau aufweist, der aus zwei aktiven und symmetrisch geschalteten Elementen (25, 26) besteht.

10. Schaltung (30, 24, 60, 24', 24") nach Anspruch 9, **dadurch gekennzeichnet, dass** die beiden aktiven Elemente (25, 26) des Stromumschalters (24) zwei Transistoren (25, 26) sind, von denen jeder eine Basis (31, 32), einen Kollektor (33, 34) und einen Emitter (27, 28) aufweist.

11. Schaltung (30, 24, 60, 24', 24") nach Anspruch 10, **dadurch gekennzeichnet, dass** die Kollektoren (27, 28) der Transistoren (25, 26) des Stromumschalters 24 miteinander verbunden sind ihre gemeinsame Verbindung mit einem Stromgenerator (29) verbunden ist.

12. Schaltung (30, 24, 60, 24', 24 ") nach Anspruch 11, **dadurch gekennzeichnet, dass** der Eingang (31 ) des Stromumschalters (24) aus der Basis (31 ) eines der Transistoren (25) besteht, der Ausgang aus dem Kollektor (34) des anderen Transistors (26) besteht und die Basis (32) dieses anderen Transistors (26) eine Referenzspannung empfängt.

13. Schaltung (30, 24, 60, 24', 24"), **dadurch gekennzeichnet, dass** sie zwei differenzielle Aufbauten nach einem der Ansprüche 3 bis 8 enthält, und jeder der beiden Aufbauten die selben Elemente wie der andere enthält, in derselben Weise geschaltet ist und jeder Aufbau (30', 30") einen Eingang aufweist und die Ausgänge jedes der Aufbauten (21', 21 ") miteinander verbunden sind.

**14.** Schaltung (30, 24, 60, 24', 24") nach einem der Ansprüche 8 bis 12, **gekennzeichnet durch** zwei Schaltungen (30', 30", 24', 24"), jede der beiden Schaltungen dieselben Elemente wie die andere aufweist und derselben Weise verbunden ist, und jede Schaltung einen Eingang (14', 14") aufweist, und die Ausgänge (34', 34") jeder der Schaltungen (30', 30", 24', 24") miteinander verbunden sind.

**15.** Integrierte Schaltung mit einer Schaltung nach einem der Ansprüche 1 bis 14.

**16.** Integrierte Schaltung und eine Kapazität (20), die gemeinsam eine Schaltung nach einem der Ansprüche 1 bis 14 bilden.

**17.** Demodulator für ein frequenzmoduliertes Signal mit einer Begrenzerschaltung (1) mit einem das frequenzmodulierte Signal empfangenden Eingang erzeugt und an wenigstens einem Ausgang (14, 14', 14") einer Impulsfolge erzeugt, deren Frequenz eine Funktion der Augenblicksfrequenz des Eingangssignals ist, einem Tiefpassfilter (3) mit einem Ausgang und einem Eingang, wobei der Ausgang ein Signal liefert, das die Modulation durch das frequenzmodulierte Signal darstellt, **gekennzeichnet durch** eine Schaltung nach einem der Ansprüche 1 bis 14, wobei diese Schaltung die Impulsfolge am Ausgang (14, 14', 14") der Begrenzerschaltung (1) empfängt und das Tiefpassfilter (3) speist.

**18.** Demodulator nach Anspruch 17, **dadurch gekennzeichnet, dass** er auf einer integrierten Schaltung ausgebildet ist.

**19.** Demodulator, **dadurch gekennzeichnet, dass** er zum Teil auf einer integrierten Schaltung ausgebildet ist und dieser Teil wenigstens eine Kapazität enthält, die mit diesem Teil verbunden ist und zusammen einen Demodulator nach Anspruch 17 bildet.

**Claims**

**1.** Circuit (30, 24, 60, 24', 24") of a demodulator of a frequency-modulated signal, the instantaneous frequency of the signal varying between a minimum frequency fmin and a maximum frequency fmax, the circuit having at least one input (14, 14', 14") receiving an input signal formed by a train of pulses, each pulse having a rising edge and a falling edge, the height of a pulse of the input signal being equal to the difference between the level of the signal before a rising or falling edge and its level after this rising or falling edge, the circuit (30, 24, 60, 24', 24") producing on an output (21, 34) of the circuit a signal whose instantaneous integral over time has a value proportional to the instantaneous frequency of the pulses making up the input signal, the circuit being **characterized in that** it carries out integration over time of the height of at least one of the edges of each pulse of the input signal of the circuit, the time of integration of the height of each integrated edge being a time τ at most equal to 1/2 fmax.

**2.** Circuit (30, 24, 60, 24', 24"), **characterized in that** it includes a capacitance (20), the charging of which at constant current for the time τ effects the integration of the integrated edge.

**3.** Circuit (30, 24, 60, 24', 24") according to Claim 2, **characterized in that** it includes at least one modified differential structure (30), the structure including at least two active elements (6, 7) mounted in symmetrical fashion, each active element having at least one connection, one of the connections (15) of an active element (7) receiving the output from a unit-gain separator stage (16) having an input (17), this input (17) being connected to a point B (19) to which are also connected a terminal of the integration capacitance (20) and a constant-current generator (18).

**4.** Circuit (30, 24, 60, 24', 24") according to Claim 3, **characterized in that** the two active elements are two transistors (6, 7), a first (6) and a second (7), each transistor (6, 7) having an emitter (12, 13), a collector (8, 9) and a base (10, 11).

**5.** Circuit (30, 24, 60, 24', 24") according to Claim 4, **characterized in that** the connection (15) receiving the output from the unit-gain separator stage (16) is the collector (19) of one of the transistors (7).

**6.** Circuit (30, 24, 60, 24', 24") according to one of Claims 4 or 5, **characterized in** the emitters (12, 13) of each of the transistors (6, 7) are connected together at a point (21) to which a current generator (22) is linked.

**7.** Circuit (30, 24, 60, 24', 24") according to Claim 6, **characterized in that** the common point (21) of connection of the emitters (12,13) of each of the emitters constitutes the output (21) of the circuit (30, 60).

**8.** Circuit (30, 24, 60, 24', 24") according to Claim 6, **characterized in that** the circuit (30) furthermore includes a current switch (24) having an input (31) and an output (32), the input (31) of the current switch (24) being connected to the point common to the emitters (12, 13) of the transistors (6, 7) and the output (34) of the current switch (24) constituting the output of the circuit (30, 24).

9. Circuit (30, 24, 60, 24', 24") according to Claim 8, **characterized in that** the current switch (24) includes a differential structure composed of two active elements (25, 26) wired in symmetrical fashion.

10. Circuit (30, 24, 60, 24', 24") according to Claim 9, **characterized in that** the two active elements (25, 26) of the current switch (24) are two transistors (25, 26) each having a base (31, 32), a collector (33, 34), and an emitter (27, 28).

11. Circuit (30, 24, 60, 24', 24") according to Claim 10, **characterized in that** the collectors (27, 28) of the transistors (25, 26) of the current switch (24) are linked together, their common connection being linked to a current generator (29).

12. Circuit (30, 24, 60, 24', 24") according to Claim 11, **characterized in that** the input (31) of the current switch (24) is made on the base (31) of one of the transistors (25) and the output on the collector (34) of the other transistor (26), the base (32) of this other transistor (26) receiving a reference voltage.

13. Circuit (30, 24, 60, 24', 24"), **characterized in that** it includes two differential structures, according to one of Claims 3 to 8, each of the two structures having the same elements as the other, wired up in the same fashion, each structure (30', 30") having an input and the outputs of each of the structures (21', 21 ") being linked to one another.

14. Circuit (30, 24, 60, 24', 24") according to one of Claims 8 to 12, **characterized in that** it includes two circuits (30', 30", 24', 24"), each of the two circuits having the same elements as the other wired up in the same fashion, each circuit having an input (14', 14"), the outputs (34', 34") of each of the circuits (30', 30", 24', 24") being linked one to the other.

15. Integrated circuit including a circuit according to one of Claims 1 to 14.

16. Integrated circuit and capacitance (20) together forming a circuit according to one of Claims 1 to 14.

17. Demodulator of a frequency-modulated signal having a limiter circuit (1) furnished with an input receiving the frequency-modulated signal and producing on at least one output (14, 14', 14") a train of pulses whose frequency of occurrence is a function of the instantaneous frequency of the input signal, a low-pass filter (3) having an output and an input, the output carrying a signal representing the modulation carried by the frequency-modulated signal, the demodulator being **characterized in that** it includes a circuit according to one of Claims 1 to 14, this circuit receiving the pulse train at the output (14, 14', 14") of the limiter circuit (1) and feeding the low-pass filter (3).

18. Demodulator according to Claim 17, **characterized in that** it is embodied on an integrated circuit.

19. Demodulator, **characterized in that** it is embodied in part on an integrated circuit, this part and at least one capacitance connected to this part together forming a demodulator according to Claim 17.

ART ANTÉRIEUR

FIG.1

FIG.2

FIG.3-1

FIG.3-2

FIG.3-3

FIG.3

**FIG.4**

EP 0 778 669 B1

FIG.5

FIG.5-1

FIG.5-2

FIG.5-3

FIG.5-4

FIG.5-5

EP 0 778 669 B1

FIG.6

EP 0 778 669 B1

$e_1(t)$     FIG. 7-1

$e_2'(t)$     FIG. 7-2

$e_2''(t)$     FIG. 7-3

$e_4'(t)$     $V_{ref}$     FIG. 7-4

$e_4''(t)$     $V_{ref}$     FIG. 7-5

$e_5'(t)$     1   0     FIG. 7-6

$e_5''(t)$     1   0     FIG. 7-7

FIG. 7     1   0     FIG. 7-8

EP 0 778 669 B1